# EUROPEAN PATENT SPECIFICATION

(11) **EP 3 457 824 B1**
(45) Date of publication and mention of the grant of the patent: **05.02.2020**
(21) Application number: 18186139.4
(22) Date of filing: 27.07.2018
(51) Int. Cl.: H05K 5/00, H05K 7/20

(54) **ELECTRONIC UNIT FOR VEHICLES**
ELEKTRONIKEINHEIT FÜR FAHRZEUGE
UNITÉ ÉLECTRONIQUE POUR VÉHICULES

(30) Priority: 19.09.2017 IT 201700104682
(43) Date of publication of application: 20.03.2019
(73) Proprietor: Magneti Marelli S.p.A., 20011 Corbetta (MI) (IT)
(72) Inventor: DAPREMONT, Olivier, 86100 Châtellerault (FR); MAIRONE, Claudio, I-20011 Corbetta (Milano) (IT)
(74) Representative: Frontoni, Stefano

(56) References cited:
- EP-A1- 0 607 879
- DE-A1- 4 215 041
- DE-A1-102011 011 447
- DE-A1-102014 207 039
- DE-A1-102015 206 480
- US-A- 5 822 188
- US-A1- 2015 342 085

## Description

The present invention regards in general the field of electronic units for vehicles. More in particular, the present invention refers to on-board electronic units that operate as processors for a series of peripherals of the vehicle itself.

Today, this type of electronic unit is increasingly present on motor vehicles, not only on high-range motor vehicles but also on low-range ones, since the equipment provided by automobile manufacturers includes an increasing number of electronic devices for improving safety and/or comfort, see DE4215041A.

It should be noted that the electronic units of the type in question that are currently used have a metal frame, which defines the outer casing of the unit, as likewise its internal skeleton, and contains the electronic components and moreover a ventilation system for cooling. The structure of the above units in effect resembles that of the case of a personal computer.

With reference to the above known solutions, the present applicant has identified a series of drawbacks.

In the first place, during assembly, the electronic components of the aforesaid units may be subject to the presence of metal swarf that is generated by the operations of assembly of the metal frame mentioned above and of connection of the components thereon. In particular, connection of the parts via screws is the main factor responsible for production of this type of swarf. The swarf in question may damage the electronic boards or in any case cause malfunctioning of the units.

Moreover, the solutions used today do not altogether satisfy the requirements of automobile manufacturers for simplification of the product and of the production process, these requirements being increasingly stringent.

In the above context, the object of the present invention is to provide an electronic unit that will overcome the aforesaid drawbacks.

The above object is achieved via an electronic unit according to Claim 1.

Further characteristics and advantages of the invention will emerge clearly from the ensuing description with reference to the annexed drawings, which are provided purely by way of non-limiting example and in which:

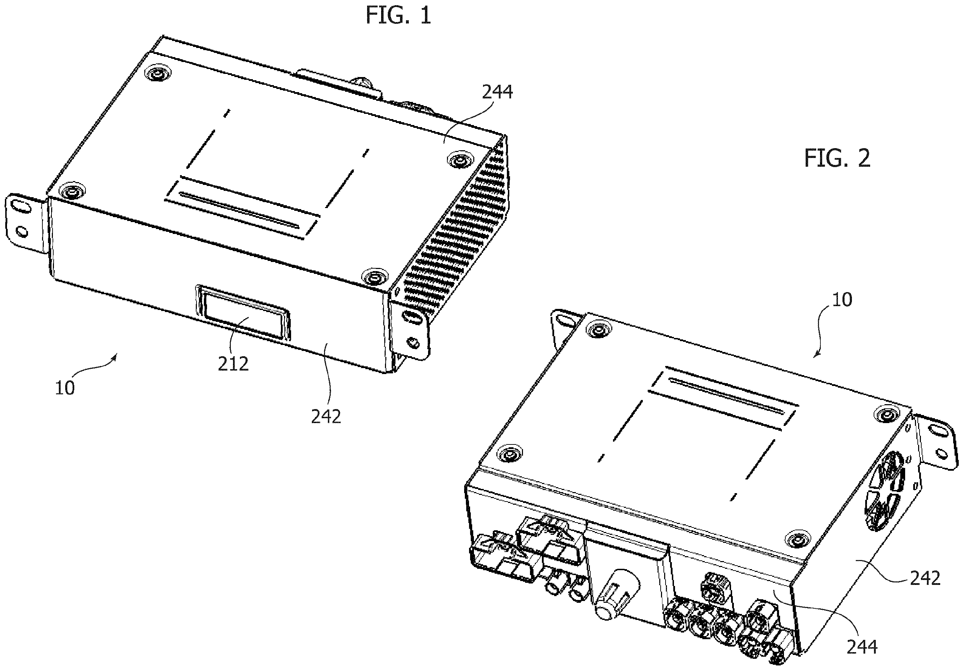

- Figure 1 illustrates a preferred embodiment of the electronic unit described herein, according to an axonometric view from the front side;
- Figure 2 illustrates the electronic unit of Figure 1 according to an axonometric view from the rear side;

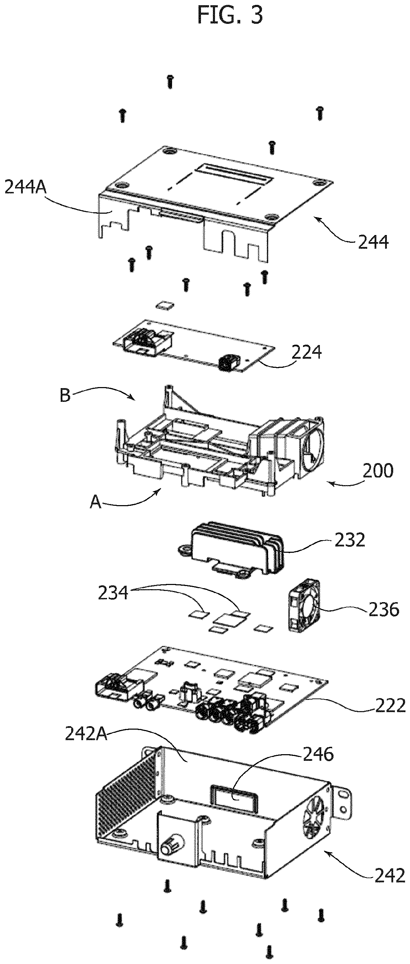

- Figure 3 is an exploded axonometric view of the electronic unit of Figure 1;
- Figure 4 is an axonometric view of the unit of Figure 1 partially dismantled;

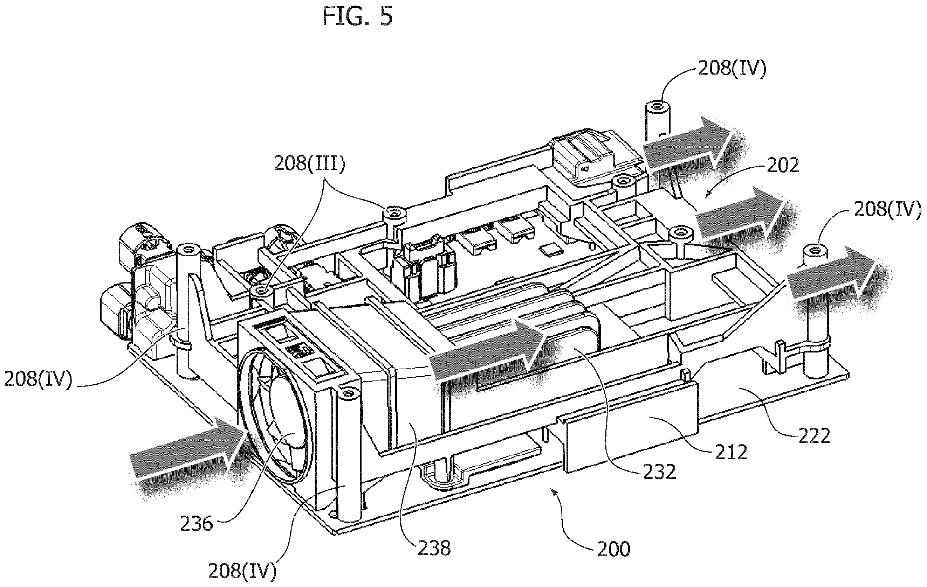

- Figure 5 is a schematic illustration of the modality of cooling of the unit of Figure 1; and
- Figure 6 illustrates the mode of assembly of the electronic unit of Figure 1.

In the ensuing description, various specific details are illustrated aimed at enabling an in-depth understanding of the embodiments. The embodiments may be obtained without one or more of the specific details, or with other methods, components, materials, etc. In other cases, known structures, materials, or operations are not shown or described in detail so that various aspects of the embodiment will not be obscured.

The references used herein are provided merely for convenience and hence do not define the sphere of protection or the scope of the embodiments.

As mentioned above, the present invention regards an electronic unit for vehicles, designed to operate as processor for a set of peripherals of the vehicle. For instance, the aforesaid unit may be designed for controlling vehicle's cluster displays, HUD displays, central displays, passenger displays, loudspeakers and microphones.

The unit described herein may present the same electronic components as those of the solutions according to the prior art, which are necessary for performing the function indicated above.

In general, the unit in question will comprise a processor module and one or more modules for exchange of data with external systems.

As compared to the known solutions, the unit described herein is characterized in that its casing comprises a frame made of polymeric material, fastened to which are the processor module and the data-exchange modules referred to above, and at least one outer metal sheet designed to define one or more outer walls of the casing, which is fixed to the aforesaid frame made of polymeric material.

The aforesaid frame constitutes an internal skeleton of the electronic unit, fixed on which are both the electronic components and the metal sheets designed to define the outer walls of the casing.

Preferably, connection of the various parts to the frame is obtained via screws that penetrate into the plastic material of the frame. The frame itself may be provided with portions designed to constitute a reference for precise and correct positioning of the various parts on the frame. Moreover, in the invention, the frame is provided with a portion configured for defining a passage for the air that is made to flow through the unit by a ventilation device provided in the unit itself.

The frame in question may be made, for example, of polycarbonate in combination with ABS (acrylonitrile-butadiene-styrene), and a possible coating.

Preferably, the aforesaid frame is constituted by a single body, obtained, for example, via injection moulding.

In general, the frame described herein enables simplification of the structure of the electronic unit, as likewise of the process of production and assembly thereof. The frame in question also overcomes the drawback discussed above with reference to the known solutions, represented by the metal swarf that might damage the electronic board, since with the use of this frame any possible plastic swarf that might be produced during the process of production of the electronic unit will have no adverse effect on the electronic components of the unit.

Illustrated in the figures is a preferred embodiment of the unit described herein.

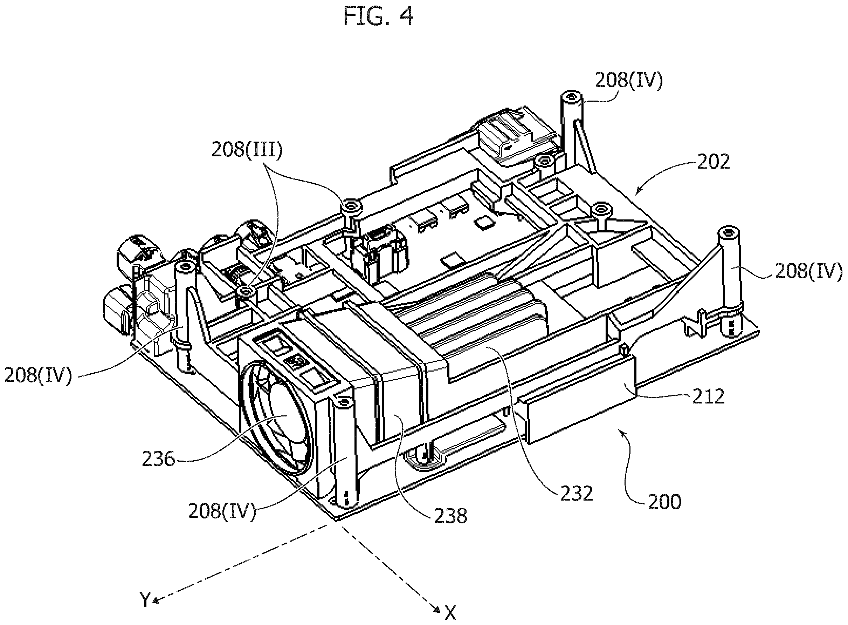

According to this embodiment, the electronic unit, designated as a whole by the reference number 10, comprises a frame 200 made of polymeric material, which defines a main portion 202 constituted by a grid of beam-like elements that extend in the two main directions X, Y of the unit (Figure 4). This grid of elements defines, on the main portion 202, a series of openings 206.

In pre-set positions of the main portion 202, the frame 200 has a series of cylindrical formations 208(I-IV), which are axially bored and are provided for connection via screws of the electronic components and of the metal sheets of the unit 10 to the frame 200, as will be described in detail hereinafter.

The formations 208 are oriented in a direction orthogonal to the directions X, Y and give out on both of the main sides A and B of the portion 202. In particular, as may be seen in Figure 4, some formations 208 extend axially in such a way as to give out on both of the opposite sides of the portion 202. At the same time, other formations 208 extend only on one side of the above portion.

With reference to each side of the portion 202, there may be identified distinct sets of formations 208 - namely, the formations 208(I), 208(II), 208(III) and 208(IV) - which are each provided for assembly and/or connection of one or more specific parts of the unit 10. Preferably, the formations 208 of one and the same set reach, on the corresponding side, the same height so as to define together a resting surface for the part that is to be fixed thereto, this surface is parallel to the geometrical plane defined by the directions X and Y.

In preferred embodiments, it is envisaged that the formations 208 will be provided with smooth, i.e., non-threaded, internal holes and that the screws inserted in these holes during assembly of the various parts to the frame 200 will tap into the walls so as to form respective threads. Clearly, this considerably simplifies the process of production of the frame 200. On the other hand, as already mentioned above, the plastic swarf generated by insertion of the screws into the holes of the formations is altogether harmless for the electronic components of the unit.

With reference now to the electronic components, in an altogether conventional way these are carried on printed-circuit boards. It is these boards that are fixed via screws to the formations 208 and, for this purpose, they envisage holes in pre-set positions, which are to be aligned with the axial holes of the formations 208 when the electronic board is set in the correct position of assembly, against the aforesaid formations.

With specific reference to the preferred embodiment illustrated in the figures, this envisages two distinct electronic boards 222, 224, which are fixed at the two opposite sides of the frame 200 on respective sets of formations 208, as will be illustrated in what follows.

In various preferred embodiments, as in the one illustrated, the electronic unit described herein comprises a dissipater body 232 coupled to provide heat exchange, with the aid of thermally conductive plates 234, with a series of components of the electronic board 222, in particular with the microprocessor and the memory modules associated thereto. Moreover, the electronic unit described herein comprises a motor-driven ventilation device with fan 236, provided for forcing a flow of air through the unit 10.

The frame 2 made of polymeric material has a set of formations 208 - specifically, the formations 208(1) - which are provided for assembly and fixing of the dissipater body 232 via screws, and, in the proximity of these formations, a portion 238 that is shaped like a channel and extends in the main direction Y starting from the above formations. The portion 238 is designed to house the ventilation device 236, at its end further away from the formations 208 for fixing of the dissipater body 232, and moreover has the function of conveying the air that is forced by the device 236, directing it against the dissipater body 232. In various preferred embodiments, as in the one illustrated, the portion 238 defines a section of passage of the air that decreases in the direction from the ventilation device 236 to the dissipater body 232, this in order to generate a Venturi effect on the flow of air.

Finally, the unit 10 comprises two metal sheets 242, 244, which are provided for defining the outer walls of the unit 10, and which are also fixed, via screws, on formations 208 of the polymeric frame dedicated thereto. In particular, the metal sheet 242 is set against the electronic board 222 and is fixed to the formations 208 on which the electronic board 222 rests.

In various preferred embodiments, the above metal sheets have, on one or more sides, openings and/or walls cut out for enabling some of the electronic components or else directly the frame made of polymeric material to give out onto the outside. In this connection, the metal sheet 244 has a wall 244A cut out so as to define an irregular series of jagged indentations, in which the connector modules carried by the electronic board 222 are arranged. When the metal sheet is coupled to the frame, the corresponding side of the unit 10 will be closed by the wall 244A, by the connectors of the electronic board 222, and by portions of the frame 200 itself.

In various preferred embodiments, the electronic unit 10 moreover envisages an antenna module, which is also set on the electronic board 222. The main portion 202 of the frame defines a stretch of wall 212 that is pre-arranged for being located up against the antenna module, separating the latter from the outside of the electronic unit. On its corresponding wall 242A, the metal sheet 242 has an opening 246 that allows the stretch of wall 212 of the frame to give out onto the outside. Thanks to this configuration, the antenna module is protected by the casing of the unit 10, but without any risk of the metal sheets 242 and 244 possibly affecting operation thereof.

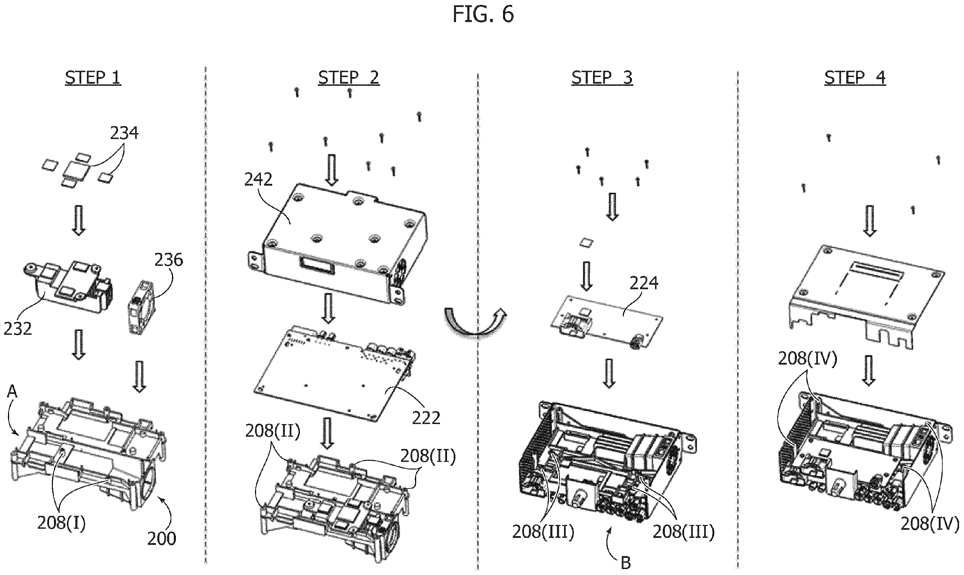

With reference to Figure 6, the sequence of assembly envisaged for assembly of the electronic unit 10 illustrated will now be described.

The frame 200 is first oriented with its side A facing the power-supply side of the components.

With the frame in the aforesaid position, the dissipater body 232 is hence rested on the set of the formations 208(I), and the ventilation device 236 is housed within the channel-shaped portion 238. The thermally conductive plates 234 are then applied on the dissipater body 232. Next, the electronic board 222 is set on the formations 208(II), oriented with the side of the components facing the frame 200 in such a way that the electronic components required will come into contact with the thermally conductive plates 234. The metal sheet 242 is then positioned on the opposite side of the board, and a corresponding number of screws are screwed into the axial holes of the formations 208, tapping, as has been seen above, their respective surfaces so as to form a thread.

At this point, the ensemble obtained is turned over so that the side B of the frame 200 will be facing the power-supply side of the components. With the frame in this new position, the electronic board 224 is hence fixed to the formations 208(III), and finally the metal sheet 244 is fixed on the formations 208(IV). Also in this case, fixing is obtained via screws that are screwed into the axial holes of the formations, cutting a thread into the surfaces thereof.

In the light of the foregoing, it is evident that the frame in question constitutes the skeleton which carries, and fixed on which are, all the other components and the various parts of the electronic unit. This frame performs a supporting function in regard to the above components and parts, and moreover, in the context of the process of assembly of the unit, it operates as reference for obtaining precise and correct positioning thereof, through its cylindrical formations 208.

The process of assembly illustrated above for the frame described is suited to being readily automated, affording high quality at low production costs.

On the other hand, as compared to known solutions, the electronic unit described herein is structurally simpler and also lighter.

Of course, without prejudice to the principle of the invention, the details of construction and the embodiments may vary, even significantly, with respect to what has been illustrated herein purely by way of non-limiting example, without thereby departing from the scope of the invention, as defined by the annexed claims.

## Claims

1. An electronic unit for vehicles, comprising a casing containing a processor module and one or more modules for exchange of data with external systems, said casing comprising a frame (200) made of polymeric material, fastened to which are said processor module and said data-exchange modules, and at least one outer metal sheet (242, 244) designed to define one or more outer walls of said casing, which is fixed to said frame made of polymeric material (2),
said unit comprising an electronic board on which said processor module is set, wherein:
- said unit comprises a dissipater body (232) coupled to said processor module so as to provide heat exchange, and a ventilation device (236) for forcing air through said unit; and
- said frame (200) has a shaped portion (238) that defines a passage for the air forced by said ventilation device.

2. The unit according to Claim 1, wherein said metal sheet (242, 244) is fixed to said frame made of polymeric material via screws that penetrate into the plastic material of said frame (200).

3. The unit according to Claim 1 or Claim 2, wherein said frame comprises a plurality of axially bored cylindrical formations (208) for connection via screws of said processor module, said data-exchange modules, and said outer metal sheet.

4. The unit according to Claim 3, wherein said frame (200) has distinct sets of said formations, and wherein the formations of said sets define respective resting surfaces that are located at different heights.

5. The unit according to Claim 1, wherein said shaped portion (238) defines a mouth for outflow of the air onto said dissipater body.

6. The unit according to Claim 1 or Claim 5, wherein said shaped portion (238) defines a decreasing section of flow in the direction of said dissipater body so as to generate a Venturi effect in said flow of air.

7. The unit according to any one of the preceding claims, wherein said frame (200) has one or more stretches of wall that define one or more portions of one or more of the outer walls of said casing.

8. The unit according to any one of the preceding claims, comprising an antenna module, wherein said frame (200) has a portion (212) designed to define a portion of outer wall of said casing that separates said antenna module from the outside.

9. The unit according to any one of the preceding claims, wherein said frame is made of a single piece.

10. The unit according to any one of the preceding claims, wherein said frame is obtained via injection moulding.

11. The unit according to any one of the preceding claims, wherein said frame is made of one of the following materials or of materials deriving from combinations thereof: polycarbonate and ABS (Acrylonitrile-butadiene-styrene).

## Patentansprüche

1. Elektronische Einheit für Fahrzeuge, die ein Gehäuse mit einem Prozessormodul und eines oder mehrere Module zum Datenaustausch mit externen Systemen aufweist,
wobei das Gehäuse einen Rahmen (200) aus Polymermaterial, an dem das Prozessormodul und die Datenaustauschmodule befestigt sind, und mindestens ein äußeres Metallblech (242, 244) umfasst, das dafür vorgesehen ist, eine oder mehrere Außenwände des Gehäuses zu definieren, und das an dem Rahmen aus Polymermaterial (2) befestigt ist,
wobei die Einheit eine elektronische Platine aufweist, auf welcher das Prozessormodul angeordnet ist, wobei:
- die Einheit einen Kühlkörper (232) umfasst, der mit dem Prozessormodul gekoppelt ist, um einen Wärmeaustausch bereitzustellen, und eine Ventilationsvorrichtung (236), um Luft durch die Einheit zu zwingen; und
- der Rahmen (200) einen geformten Abschnitt (238) aufweist, der einen Durchlass für die durch die Ventilationsvorrichtung gezwängte Luft definiert.

2. Einheit nach Anspruch 1, wobei das Metallblech (242, 244) an dem Rahmen, der aus Polymermaterial hergestellt ist, mittels Schrauben befestigt ist, die in das Kunststoffmaterial des Rahmens (200) eindringen.

3. Einheit nach Anspruch 1 oder Anspruch 2, wobei der Rahmen eine Vielzahl von axial gebohrten zylindrischen Ausformungen (208) zur Verbindung des Prozessormoduls, der Datenaustauschmodule und des äußeren Metallblechs mittels der Schrauben umfasst.

4. Einheit nach Anspruch 3, wobei der Rahmen (200) einzelne Sätze der Ausformungen aufweist, und wobei die Ausformungen der Sätze entsprechende Auflageflächen definieren, die in unterschiedlichen Höhen angeordnet sind.

5. Einheit nach Anspruch 1, wobei der geformte Abschnitt (238) eine Öffnung für den Abfluss der Luft auf den Kühlkörper definiert.

6. Einheit nach Anspruch 1 oder Anspruch 5, wobei der geformte Abschnitt (238) einen abnehmenden Strömungsquerschnitt in Richtung des Kühlkörpers definiert, um einen Venturi-Effekt in der Luftströmung zu erzeugen.

7. Einheit nach einem der vorhergehenden Ansprüche, wobei der Rahmen (200) einen oder mehrere Wandabschnitte aufweist, die einen oder mehrere Bereiche von einer oder mehreren der Außenwände des Gehäuses definieren.

8. Einheit nach einem der vorhergehenden Ansprüchen, die ein Antennenmodul umfasst, wobei der Rahmen (200) einen Abschnitt (212) aufweist, der ausgebildet ist, einen Bereich der Außenwand des Gehäuses zu definieren, die das Antennenmodul von dem Äußeren trennt.

9. Einheit nach einem der vorhergehenden Ansprüche, wobei der Rahmen aus einem einzigen Stück hergestellt ist.

10. Einheit nach einem der vorhergehenden Ansprüche, wobei der Rahmen durch Spritzgießen gefertigt ist.

11. Einheit nach einem der vorhergehenden Ansprüche, wobei der Rahmen aus einem der folgenden Materialien oder aus Materialien, die aus Kombinationen davon hervorgehen, hergestellt ist: Polycarbonat und ABS (Acrylnitril-Butadien-Styrol).

## Revendications

1. Unité électronique pour véhicules, comprenant un boîtier contenant un module processeur et un ou plusieurs modules pour un échange de données avec des systèmes externes,
ledit boîtier comprenant un cadre (200) constitué de matière polymère, auquel sont attachés ledit module processeur et lesdits modules d'échange de données, et au moins une feuille métallique extérieure (242, 244) conçue pour définir une ou plusieurs parois extérieures dudit boîtier, qui est fixée audit cadre constitué de matière polymère (2),
ladite unité comprenant une carte électronique sur laquelle ledit module processeur est placé, dans laquelle :
- ladite unité comprend un corps dissipateur (232) couplé audit module processeur de façon à fournir un échange de chaleur, et un dispositif de ventilation (236) permettant de forcer de l'air à travers ladite unité ; et
- ledit cadre (200) a une partie façonnée (238) qui définit un passage pour l'air forcé par ledit dispositif de ventilation.

2. Unité selon la revendication 1, dans laquelle ladite feuille métallique (242, 244) est fixée audit cadre constitué de matière polymère via des vis qui pénètrent dans la matière plastique dudit cadre (200).

3. Unité selon la revendication 1 ou la revendication 2, dans laquelle ledit cadre comprend une pluralité de formations cylindriques alésées axialement (208) pour une liaison via des vis dudit module processeur, desdits modules d'échange de données, et de ladite feuille métallique extérieure.

4. Unité selon la revendication 3, dans laquelle ledit cadre (200) a des ensembles distincts desdites formations, et dans laquelle les formations desdits ensembles définissent des surfaces de support respectives qui sont situées à des hauteurs différentes.

5. Unité selon la revendication 1, dans laquelle ladite partie façonnée (238) définit une embouchure pour un écoulement de l'air sur ledit corps dissipateur.

6. Unité selon la revendication 1 ou la revendication 5, dans laquelle ladite partie façonnée (238) définit une section décroissante d'un flux dans la direction dudit corps dissipateur de façon à générer un effet Venturi dans ledit flux d'air.

7. Unité selon l'une quelconque des revendications précédentes, dans laquelle ledit cadre (200) a une ou plusieurs étendues de paroi qui définissent une ou plusieurs parties d'une ou plusieurs des parois extérieures dudit boîtier.

8. Unité selon l'une quelconque des revendications précédentes, comprenant un module antenne, dans laquelle ledit cadre (200) a une partie (212) conçue pour définir une partie d'une paroi extérieure dudit boîtier qui sépare ledit module antenne de l'extérieur.

9. Unité selon l'une quelconque des revendications précédentes, dans laquelle ledit cadre est constitué d'une seule pièce.

10. Unité selon l'une quelconque des revendications précédentes, dans laquelle ledit cadre est obtenu via un moulage par injection.

11. Unité selon l'une quelconque des revendications précédentes, dans laquelle ledit cadre est constitué d'une des matières suivantes ou de matières dérivant de combinaisons de celles-ci : polycarbonate et ABS (acrylonitrile-butadiène- styrène).
